Europäisches Patentamt

European Patent Office

Office européen des brevets

(19)

(11) Veröffentlichungsnummer: **0 174 635**
A2

(12) **EUROPÄISCHE PATENTANMELDUNG**

(21) Anmeldenummer: 85111420.7

(22) Anmeldetag: 10.09.85

(51) Int. Cl.⁴: **H 01 S 3/08**
**H 01 S 3/19**

(30) Priorität: 14.09.84 DE 3433902

(43) Veröffentlichungstag der Anmeldung:
19.03.86 Patentblatt 86/12

(84) Benannte Vertragsstaaten:
DE FR GB

(71) Anmelder: **Siemens Aktiengesellschaft**
**Berlin und München Wittelsbacherplatz 2**
**D-8000 München 2(DE)**

(72) Erfinder: **Wolf, Hans Dietrich, Dr.**
**Höhenkirchener Strasse 40**
**D-8011 Hohenbrunn(DE)**

(54) **Halbleiterlaser für hohe optische Ausgangsleistung mit verringerter Spiegelaufheizung.**

(57) Halbleiterlaser (elektrisch oder optisch gepumpt) mit Quantum-Well-Struktur und mit in engen Grenzen bemessenen Abstand (11, 12) des jeweiligen Spiegels (41, 141) vom Ende der laseraktiven Zone (6, 52).

FIG 1

EP 0 174 635 A2

Halbleiterlaser für hohe optische Ausgangsleistung mit
verringerter Spiegelaufheizung.

Die vorliegende Erfindung bezieht sich auf einen Halbleiterlaser, wie er im Oberbegriff des Patentanspruchs 1
angegeben ist.

Es ist bekannt, daß für Halbleiterlaser bzw. Laserdioden,
die insbesondere auf hohe Ausgangsleistung der emittierten Laserstrahlung ausgelegt sind, das Problem der Erhitzung der Spiegelflächen des optischen Resonators des
Lasers besteht und die Leistungsfähigkeit eines solchen
Lasers erheblich beschänken kann.  Bei Überschreiten der
für die Aufheizung der jeweiligen Spiegelfläche zulässigen
Maximalbelastung kommt es nämlich zu abrupter Alterung und
Zerstörung des Spiegels bzw. Verlust eines wesentlichen Anteils der spiegelnden Eigenschaft.  Sogar bei Ausgangsleistungen, die noch erheblich unterhalb der maximalen Belastung liegen, wird bereits erhebliche langzeitige Alterung
der Spiegeleigenschaften beobachtet.

Bei einem Gallium-Aluminiumarsenid-Halbleiterlaser des Prinzips der "window structure" (siehe IEEE EJourn. Quantum
Electr., Vol.QE 15 (1979), pp. 775; Appl. Phys. L. 34(1979)
pp. 637; US-PS 4 349 905) ist vorgesehen, daß die laseraktive Zone bzw. den Halbleiterkörper im Bereich dieser laseraktiven Zone bei einem Doppelheterostruktur-Injektionslaser durch örtlich begrenzte Zink-Diffusion in kurze n-
dotierte und längere p-dotierte Längsabschnitte aufgeteilt
ist.  Die Spiegelflächen sind im Bereich der n-dotierten
Abschnitte vorgesehen.  Dort ist die Absorption von in den
längeren p-dotierten Abschnitten erzeugter Laserstrahlung erheblich reduziert, womit die Wärmebelastung der jeweiligen Spiegelfläche zu Lasten jedoch aufwendiger Herstellung
der Diode verringert werden konnte.

Eine aus der US-PS 4 371 966 bekannte Laserdiode hat an
nicht zu pumpendes Halbleitermaterial angrenzende Spiegel,
jedoch gehören diese zu einer insgesamt passiven Wellenleiterstruktur.

Aufgabe der vorliegenden Erfindung ist es, einen solchen
Aufbau eines Halbleiterlasers mit verringerter Wärmebelastung der Resonator-Spiegelflächen anzugeben, der in technologisch einfacher Weise und gut reproduzierbar hergestellt
werden kann.

Diese Aufgabe wird mit den Merkmalen des Patentanspruchs 1
gelöst. Weitere Ausgestaltungen und Weiterbildungen der Erfindung gehen aus den Unteransprüchen hervor.

Ohne daß ein Zusammenhang mit den Resonator-Spiegelflächen
gegeben ist, ist aus Jap. Journ. Appl. Physics, Bd.22 (1983),
L751-L753 ein Halbleiterlaser mit "quantum well"-Struktur
bekannt, an dem festgestellt worden ist, daß in wahlweise
nicht gepumpten Bereichen dieses Lasers die Absorption der
in dessen gepumpten Bereichen erzeugten Laserstrahlung
kleiner ist, als dies für konventionelle Doppelheterostrukturen der Fall ist. Bei der Erfindung wird diese Erkenntnis verwendet, indem man, und zwar auf eng bemessene
Nähe der Spiegel des optischen Resonators begrenzt, jeweils
einen ungepumpten Bereich im Halbleitermaterial vorsieht.
Die bei einer solchen Laserstruktur relativ geringe Absorption von Laserstrahlung in ungepumpten Bereichen in Nähe der
Spiegel führt zu nur geringen Ladungsträgerkonzentrationen
im Bereich der Spiegel. Die Längsabmessung des an den jeweiligen Spiegel angrenzenden ungepumpten Bereiches ist bei
der Erfindung so bemessen, daß noch kein wesentlicher Verlust an Ausgangsleistung des gesamten Halbleiterlasers, d.h.
der gepumpten laseraktiven Bereiche, eintritt, andererseits aber im Bereich der jeweiligen Spiegelfläche erzeugte
Wärme im Bereich des für den jeweiligen Spiegel zulässigen
Maßes bleibt. Die Länge des jeweiligen ungepumpten
Bereiches, d.h. der jeweilige Abstand zwischen Spiegel und
Ende der laseraktiven Zone ist erfindungsgemäß mit 5 bis 30
μm, vorzugsweise auf 10 bis 15 μm, bemessen.

Das Maß für eine optimale Länge des an den jeweiligen Spiegel sich anschließenden ungepumpten Bereiches des Halbleiterkörpers des Lasers ist auf z.B. ca. drei Diffusionslängen
für die Ladungsträger, insbesondere der Löcher, in den ungepumpten Bereichen der aktiven Zone begrenzt. Wie angegeben,
gilt dies direkt für optisch gepumpte Halbleiterlaser, wohingegen bei Injektionslasern noch die zusätzliche Verbreiterung des Ladungsträgerprofils von ca. 2 μm im Bahngebiet des
Lasers hinzuzurechnen wäre.

Weitere Erläuterungen der Erfindung gehen aus der nachfolgenden, anhand der Figuren gegebenen Beschreibung hervor.

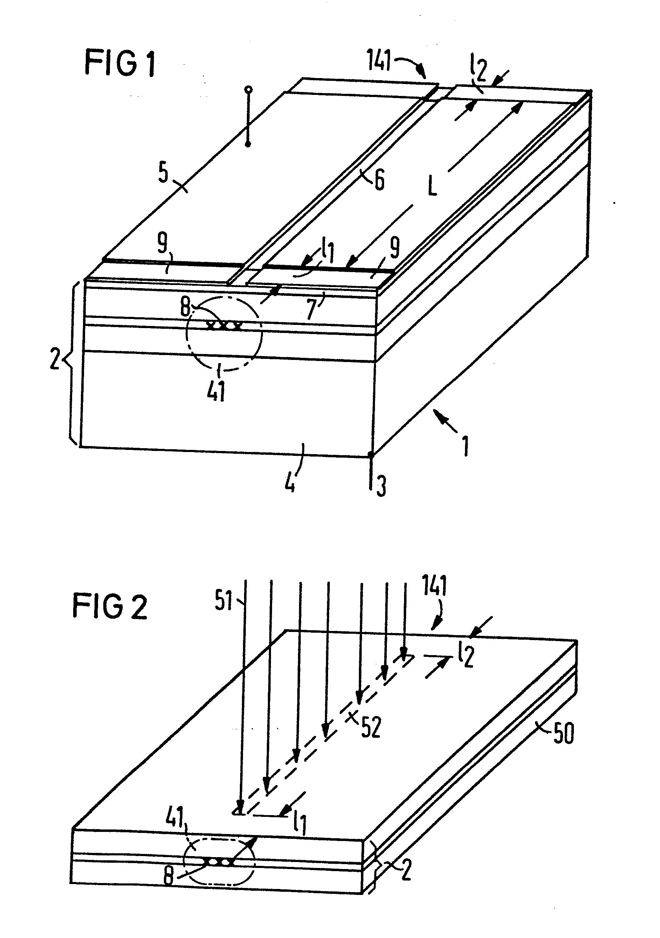

Fig.1 zeigt eine erfindungsgemäße Ausführungsform einer Injektions-Halbleiter-Laserdiode 1. Mit 2 ist ein an sich
bekannter, insbesondere epitaktisch hergestellter Schichtaufbau eines "quantum well"-Halbleiterlasers bezeichnet.
Der eine elektrische Anschluß-Kontakt 3 ist beispielsweise
an dem Anteil 4 der Schichtfolge 2 angebracht, wobei der
Anteil 4 insbesondere der Substratkörper der Diode 1 ist.
Die Gegenelektrode ist eine nahezu ganzflächige Metallbeschichtung 5 der in der Fig.1 oberen Oberfläche der Diode 1.
Diese Metallbeschichtung 5 reicht auch in die aus Fig.1 ersichtliche streifenförmige Vertiefung 6 hinein und liegt
dort auf der obersten, aus Halbleitermaterial bestehenden
Schicht 7 der Schichtfolge 2 auf. Die Struktur dieser Vertiefung 6 bestimmt Streifenform und Lage des laseraktiven
Streifens, dessen Querschnittsfläche im Bereich der Vorder-

**0174635**

front der Diode 1 mit 8 bezeichnet ist. Infolge der an den (in den Figuren vorderen und hinteren) Stirnflächen 41,141 auftretenden, auf dem Brechungsindex des Materials des Halbleiterkörpers bzw. der Schichtfolge 2 beruhenden Spiegeleigenschaften und/oder infolge zusätzlicher bekanntermaßen vorgesehener Verspiegelung dieser Oberflächen liegt ein optischer Resonator mit Resonatorspiegeln 41,141 vor. Mit 9 sind streifenförmige Beschichtungen aus elektrisch isolierendem Material, wie z.B. Aluminiumoxid, bezeichnet. Im Bereich dieser Schichten 9 liegt die Metallbeschichtung 5 nicht auf dem Halbleitermaterial der Schicht 7 auf, so daß in den Bereichen dieser Schichten 9 keine direkte Stromzuführung in den Körper der Diode 1 erfolgt. Infolge der mit L bemessenen Länge der Metallbeschichtung 5 ist auch die Injektionsanregung im Bereich der laseraktiven Zone (mit der Querschnittsfläche 8) auf diese Länge L beschränkt. Die an beiden gegenüberliegenden Enden, vorgesehenen Abstände Längenanteile $l_1$ und $l_2$ ($L+l_1+l_2$ = gesamte Länge der Diode 1) ergeben die ungepumpten Teilbereiche der laseraktiven Zone, d.h. die Längenanteile des optischen Resonators, in denen keine Laserstrahlung erzeugt wird, jedoch gemäß der Erfindung verringerte Absorption der Laserstrahlung eintritt. Aufgrund der verringerten Absorption ist die Erwärmung im Bereich der in Fig.1 stirnseitigen Fläche 41 des Körpers der Diode 1 geringer als dies der Fall wäre, wenn die Abmessung L gleich der Gesamtlänge des Körpers der Diode 1 wäre. Dasselbe gilt für die in bezug auf die Länge L gegenüberliegende (in Fig.1 rückwärtige) Stirnfläche 141 des Körpers der Diode 1. Wie dies für Laserdioden überwiegend der Fall ist, sind diese Stirnflächen gleichzeitig die Spiegelflächen des optischen Resonators der Laserdiode 1. Mit der beschriebenen Maßnahme ist somit die verringerte Wärmebelastung der Spiegelflächen des optischen Resonators der Laserdiode erreicht.

Fig.2 zeigt einen ähnlichen Schichtaufbau für einen mit optischer Strahlung 51 gepumpten Halbleiterlaser 50. Wie aus Fig.2 ersichtlich, ist der optisch gepumpte Flächenanteil auf einen Streifen 52 beschränkt, der bis auf die Abstände 11 und 12 an die vordere bzw. rückwärtige Stirnfläche 41, 141 des Körpers des Lasers 50 heranreicht. Diese Teilbereiche der Abstände $1_1$ und $1_2$ entsprechen denjenigen der Fig.1 und haben die bereits beschriebene Wirkung hinsichtlich der Spiegel des optischen Resonators. Der Streifen 52 kann durch die Begrenzung einer entsprechend streifenförmigen Öffnung in einer (nicht dargestellten) auf dem Halbleiterkörper z.B. aufliegenden Maske bestimmt sein.

7 Patentansprüche
2 Figuren

Patentansprüche:

1. Elektrisch oder optisch gepumpter Halbleiter-Streifenlaser
mit einem Halbleiterkörper mit Schichtaufbau und mit Resonator-Spiegelflächen für eine jeweils im Abstand von der
betreffenden Spiegelfläche endende laseraktive Zone, in der
im Halbleiterkörper verlaufende Laserstrahlung erzeugt wird,
und mit Elektrodenbeschichtung,
g e k e n n z e i c h n e t   dadurch,
- daß der Schichtaufbau (2) des Halbleiterkörpers eine quantum-well-Struktur umfaßt, und
- daß dieser jeweilige Abstand (11, 12) der betreffenden
  Spiegelfläche (41, 141) vom jeweiligen Ende der im Betrieb
  gepumpten laseraktiven Zone (8) im Halbleiterkörper (2)
  5 bis 30 μm beträgt.

2. Halbleiter-Streifenlaser nach Anspruch 1,
g e k e n n z e i c h n e t       dadurch,
daß der jeweilige Abstand (11, 12) 10 bis 15 μm beträgt.

3. Halbleiter-Streifenlaser nach Anspruch 1,
g e k e n n z e i c h n e t       dadurch,
daß der jeweilige Abstand (11, 12) etwa drei Diffusionslängen der Ladungsträger beträgt.

4. Halbleiter-Streifenlaser nach Anspruch 3,
g e k e n n z e i c h n e t       dadurch,
daß der jeweilige Abstand (11, 12) bei elektrisch gepumptem
Laser jeweils noch zuzüglich 2 μm beträgt.

5. Halbleiterlaser nach Anspruch 1, 2, 3 oder 4 dadurch
g e k e n n z e i c h n e t       ,
daß der jeweilige Abstand $(1_1, 1_2)$ durch Längenbegrenzung
(L, 9; 52) der die streifenförmige laseraktive Zone (8)
ergebenden Elektrodenbeschichtung bestimmt ist (Fig.1).

6. Halbleiterlaser nach Anspruch 1, 2, 3 oder 4, g e k e n n z e i c h n e t dadurch, daß der jeweilige Abstand ($l_1$, $l_2$) durch Längenbegrenzung ($l_1$, $l_2$) des mit Pumpstrahlung (51) bestrahlten Streifens (52) des Halbleiterkörpers (2) bestimmt ist (Fig.2).

7. Halbleiterlaser nach Anspruch 6, g e k e n n z e i ch - n e t dadurch, daß der bestrahlte Streifen (52) durch eine Maske begrenzt ist.

FIG 1

FIG 2